# EUROPEAN PATENT SPECIFICATION

(11) **EP 0 543 220 B1**
(45) Date of publication and mention of the grant of the patent: **20.12.2000**
(21) Application number: 92118855.3
(22) Date of filing: 04.11.1992
(51) Int. Cl.: H04N 7/24

(54) **Method and apparatus for A/D and D/A conversion**
Verfahren und Einrichtung zur A/D- und D/A-Umwandlung
Méthode et dispositif pour conversion A/D et D/A

(30) Priority: 13.11.1991 EP 91403066
(43) Date of publication of application: 26.05.1993
(73) Proprietor: THOMSON multimedia, 92648 Boulogne Cédex (FR)
(72) Inventor: Boie, Werner, F-67100 Strasbourg (FR)
(74) Representative: Hartnack, Wolfgang, Dipl.-Ing.

(56) References cited:
- EP-A- 0 502 571
- DE-A- 3 924 505
- FR-A- 2 529 043
- US-A- 4 566 028
- US-A- 4 710 747
- PATENT ABSTRACTS OF JAPAN vol. 16, no. 108 (E-1179)17 March 1992 & JP-A-32 83 822
- GRUNDIG TECHNISCHE INFORMATIONEN vol. 31, no. 1/2, 1984, pages 3 - 7 GLAAB 'WELCHE VORTEILE BIETET DAS OVERSAMPLING-VERFAHREN DER GRUNDIG COMPACT-DISC-SPIELER'
- PATENT ABSTRACTS OF JAPAN vol. 9, no. 115 (E-315)18 May 1985 & JP-A-60 004 383
- PATENT ABSTRACTS OF JAPAN vol. 16, no. 108 (E-1179)17 March 1992 & JP-A-32 83 822
- PATENT ABSTRACTS OF JAPAN vol. 9, no. 115 (E-315)18 May 1985 & JP-A-60 004 383

## Description

The present invention relates to a method and to an apparatus for A/D and D/A conversion.

### Background

Todays consumer video A/D and D/A converters or other digital video processing systems are restricted to 8-bit resolution. The quantizing noise introduced in these systems can result in visible artefacts in gradually shaped areas of an image or can lead in applications based on some critical algorithms to very severe distortions.

It is known to use a dither signal for masking contouring or correlation effects by adding a non-correlated noise signal to the video signal prior to A/D conversion.

From DE-A-3924505 a high resolution A/D converter is known which works with oversampling. A loop filter is positioned preceeding the A/D converter. This loop filter receives the sum signal of the analogue input signal and the decimated and D/A converted output signal of the A/D converter.

From US-A-4710747 a system for increasing the accuracy and resolution of an A/D converter is known. In this system a digital filter is connected to the output of the A/D converter. A system clock provides a digital filter clock signal and a low pass filter / amplifier generates a large scale rapidly varying dither signal from the digital filter clock signal. This dither signal is fed to a summing circuit where it is added to the analogue input signal before it is fed to the A/D converter. The dither signal covers the whole input signal range of the A/D converter.

From US-A-4566028 a digital signal processing apparatus for processing dithered digital signals is known. In this document it is explained that the dither signal which varies the analog input signal of an A/D converter could have small amplitude, e.g. one-half of the signal amplitude which belongs to the least significant bit of the digitalized input signal.

### Invention

It is one object of the invention to disclose an improved method for A/D conversion. This object is achieved by the inventive method disclosed in claim 1.

In principle this inventive method consists in a method for A/D conversion wherein digital values with improved bit resolution are generated at a sampling frequency fs, having included the steps of:
- adding a D/A converted (36) periodic signal (21) varying in a number of steps and having a sampling frequency of n*fs (32) to the analog signal prior to an A/D conversion (33), wherein the peak to peak amplitude (20) of the periodic signal (21) generated in said periodic signal generator (58) equals one half of the corresponding quantisation interval of said A/D conversion (33), wherein the A/D conversion is done with predefined bit resolution and a sampling frequency of n*fs,
- converting the A/D converted digital signal in a conversion filter (34) to an output signal having an increased bit resolution wherein the bits for increa-sing the bit resolution correspond to the number of steps of the periodic signal, wherein the response of said conversion filtering has high attenuation or zero crossings at multiples of said sampling frequency fs, except for frequencies m*n* fs, m = 0, ±1, ±2, ±3, ...,
- subsampling said output signal (35) into a signal having a sampling frequency fₛ.

Advantageous additional embodiments of this inventive method are resulting from the respective dependent claim.

It is a further object of the invention to disclose an improved method for D/A conversion. This object is achieved by the inventive method disclosed in claim 2.

In principle this inventive method consists in a method for D/A conversion of a signal having a sampling frequency fs, wherein said input signal (50) has an increased bit resolution and is at first oversampled (51) with a frequency of n*fs, second intermediate values are interpolated (52), third the resulting values are added (53) to a periodic signal (21) which varies in a number of steps corresponding to the number of bits used for increasing the bit resolution of said input signal, wherein said periodic signal has a sampling frequency of n*fs, fourth the sum signal is quantized (54) to a signal with predefined lower bit resolution which is D/A converted (55) by using the sampling frequency of n*fs, wherein the peak to peak amplitude (20) of the periodic signal (21) generated in said periodic signal generator (58) equals one half of the corresponding quantisation interval of said D/A conversion (55).

Advantageous additional embodiments of this inventive method are resulting from the respective dependent claim.

It is a further object of the invention to disclose an apparatus which utilizes the inventive A/D conversion method. This object is achieved by the inventive A/D converter disclosed in claim 4.

In principle the inventive A/D converter has included a summing circuit (32) which receives an analog input signal (30) and an output signal of a D/A converter (36) and having included a clock generator (38) which generates a clock signal having a clock frequency of n*fₛ, wherein said clock signal is fed to the D/A converter (36), the output of said summing circuit being connected with an A/D converter (33) having a predefined bit resolution, in particular 8 bit resolution, and which oversamples the input sum signal n-times with a sampling frequency n*fₛ, wherein a conversion filter (34) connected to the output of said A/D converter (33) is included which adds a number of bits, in particular n bits with n>1, to the input bits for bit resolution increase and which has high attenuation or zero crossings at multiples of said sampling frequency fₛ, except for frequencies m*n*fₛ, m = 0, ±1, ±2, ±3, ... , of a following subsampler (35) which subsamples the input signal by a factor n and which outputs a digital signal with increased bit resolution and a clock frequency fₛ, and having a periodic signal generator (37) which is connected to the input of said D/A converter (36), wherein the peak to peak amplitude (20) of the generated periodic signal (21) equals one half of the corresponding quantisation interval of said A/D converter (33).

Advantageous additional embodiments of this A/D converter are resulting from the respective dependent claim.

It is a further object of the invention to disclose an apparatus which utilizes the inventive D/A conversion method. This object is achieved by the inventive D/A converter disclosed in claim 5.

In principle the inventive D/A converter includes an n-times oversampler (51) which receives a digital signal consisting of samples being produced with a clock frequency of fₛ and having a predefined increased bit resolution, in particular 8+n-bit resolution with n>1, wherein said oversampler (51) generates a digital signal consisting of samples being produced with a clock frequency of n*fₛ, and having included a following conversion filter (52) which interpolates new samples based on the samples of said oversampler (51) and outputs the corresponding signal to an adder (53) which adds a periodic signal having the same clock frequency to the output signal of said conversion filter (52), wherein the periodic signal is generated in a periodic signal generator (58), further including a following quantiser (54) which extracts the most significant bits from the samples with increased bit resolution in the output signal of said adder (53), the thus generated new samples having a reduced bit resolution, in particular 8 bit resolution, further including a following D/A converter (55) which converts the bit reduced samples and to which a clock signal generated in a clock generator (38) is fed having a clock frequency of n*fₛ, wherein the peak to peak amplitude (20) of the periodic signal (21) generated in said periodic signal generator (58) equals one half of the corresponding quantisation interval of said D/A converter (55).

Advantageous additional embodiments of this D/A converter are resulting from the respective dependent claim.

For achieving an increased bit resolution for a given A/D or D/A converter, a special multilevel dither signal in conjunction with multiple oversampling is added to the bandlimited analog input signal which is afterwards converted with a clock rate of n*fₛ and to the digital input signal, respectively.

### Drawings

Preferred embodiments of the invention will now be described with reference to the accompanying drawings, in which:
- Fig. 1: shows generally a digital video processing system;
- Fig. 2: shows the special multilevel dither signal;
- Fig. 3: depicts an inventive A/D converter;
- Fig. 4: shows the features of a conversion filter;
- Fig. 5: depicts an inventive D/A converter;
- Fig. 6: gives an illustration of the inventive conversion.

### Preferred embodiments

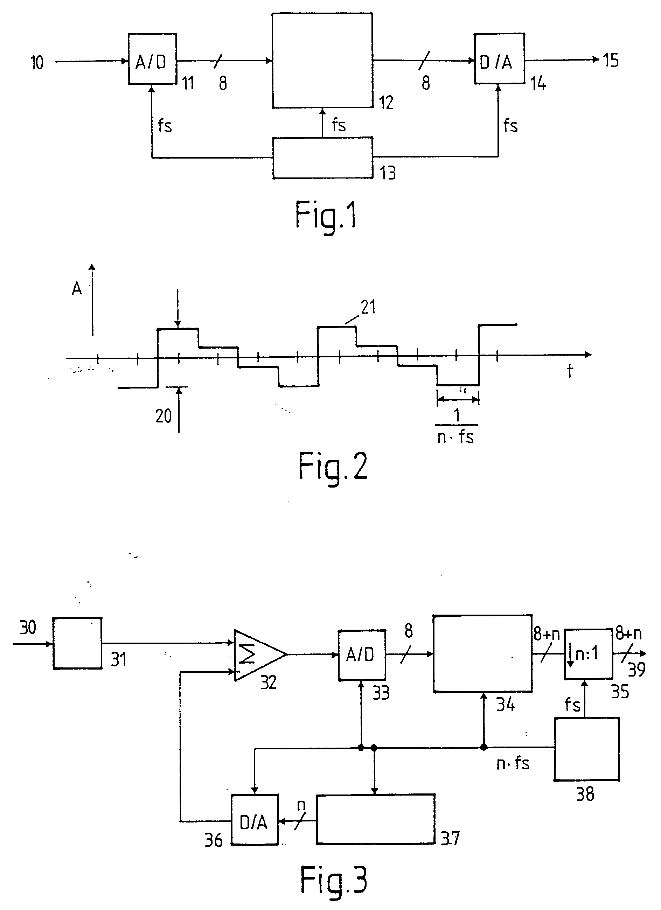

In Fig. 1 an analog input signal 10 becomes A/D converted in an A/D converter 11 which outputs respective digital signals with 8-bit resolution. The digital signals are processed in a digital unit 12 and fed with 8-bit resolution to an D/A converter 14 which outputs analog output signals 15. A/D converter 11, digital unit 12 and D/A converter 14 are controlled with a clock fₛ coming from a clock generator 13.

The special dither signal in Fig. 2 is represented by a staircase ramp signal 21 with an maximum amplitude 20 equalling a half LSB (least significant bit) amplitude of the A/D or D/A converter used. The clock 1/(n*fₛ) of the dither signal is n times higher than the sampling clock fₛ necessary to fulfill the sampling theorem for the analog input signal. The sequence of the staircase steps can also be arranged in another way.
The term 'dither' signal used in this context differs from the normal applications of dither signals used.

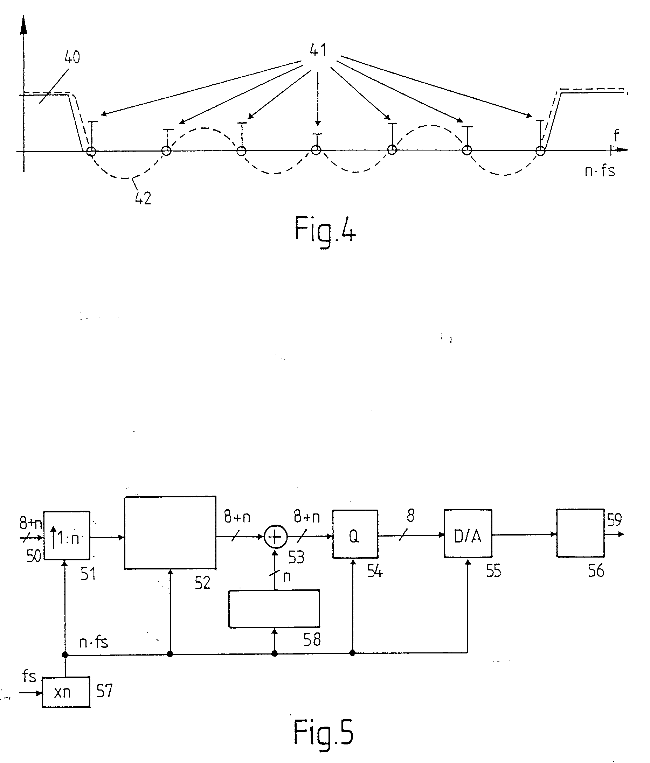

In Fig. 3 the inventive A/D converter receives an analog input signal 30 which is filtered in lowpass filter 31 with a cut frequency f_{co}, f_{co} ≤ 2*fₛ. The output signal of this filter is fed to the first input of a summing circuit 32. The output of this circuit is connected to an A/D converter 33 which oversamples with factor 'n'. The 8-bit output signal is filtered in a conversion filter 34 which adds n bits to the eight input bits, resulting in a word size of 8+n bits. Conversion filter 34 has a frequency response as indicated in Fig. 4. The 8+n bit output signal of filter 34 is sampled in subsampler 35 with a factor of 'n'.
In an n-bit counter 37 a staircase dither signal is generated and fed via D/A converter 36 to the second input of summing circuit 32. A clock generator 38 provides subsampler 35 with the clock frequency fₛ and the conversion filter 34, A/D converter 33, counter 37 and D/A converter 36 with the clock frequency n*fₛ. The output signal 39 of subsampler 35 has a resolution of 8+n bits.

The response of conversion filter 34 in Fig. 4 must have a high attenuation or, better, zero crossings at multiples of frequency fₛ, except for frequencies m*n*fₛ, m = 0, ±1, ±2, ±3, ... . Since the input video signal has been n times over-sampled the filter output signal can be down sampled afterwards without losing the increased bit resolution.

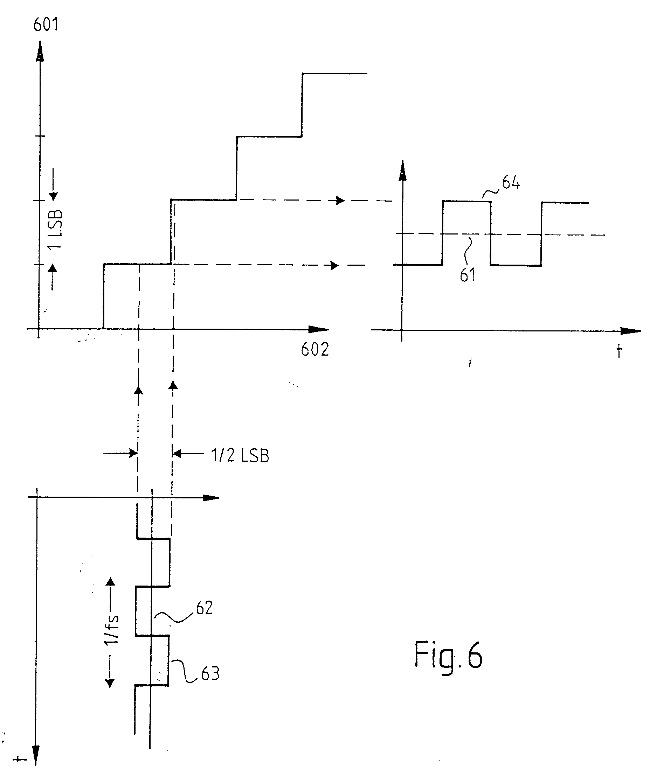

Fig. 6 will be used for a better understanding of the inventive idea. The conversion curve is depicted in the domain 'quantized amplitude' 601 over 'input amplitude' 602 of the A/D converter. The video signal is assumed to have a DC input level 62. By means of a two level (1 bit) dither signal 63 with a peak-to-peak amplitude of 1/2 LSB of the succeeding A/D converter the bit resolution of the A/D conversion can be increased by 1 bit. Due to the superimposed dither signal 63 the unfiltered output signal 64 of the A/D converter will vary in its amplitude by one bit, if the DC level 62 of the input signal 63 is smaller than 1/4 LSB or greater than 3/4 LSB within the corresponding quantizing interval. In Fig. 6 the DC level 62 is assumed to be greater than 3/4 LSB within the corresponding quantizing interval. That leads to an oscillation of the output signal with a peak-to-peak value of 1 LSB. The following conversion filtering will completely suppress this oscillation due to its zero crossings in the frequency response. The resulting output signal can than supply an intermediate DC level 61 which corresponds with an increased resolution by 1 bit.

The inventive D/A converter in Fig. 5 receives a digital input signal 50 with 8+n bit resolution. In oversampler 51 this signal is sampled with a clock rate n times higher than before. The new samples are interpolated in a conversion filter 52 which outputs 8+n bit words. In adder 53 a special n-bit multilevel dither signal according to Fig. 2 and generated in n-bit counter 58 is added to the output signal of filter 52. A quantizer 54 takes the eight most significant bits from each 8+n bit word and is connected with its output to D/A converter 55. The following analog lowpass filter 56 suppresses in the output signal 59 all the harmonics introduced by the dither signal.
A clock frequency n*fₛ, which can be generated in a frequency multiplier 57 from the clock frequency fₛ, is fed to oversampler 51, conversion filter 52, counter 58, quantizer 54 and D/A converter 55.

The invention can be applied e.g. to digital SECAM decoding in TV receivers or VCR's, in which a composite signal is converted to 8-bit words. The FM modulated colour subcarrier with its small amplitude, which is included in the composite signal, is subjected to a high degree of quantizing noise. This poses serious problems for the FM demodulation and results in 'coloured fishes' in the reconstructed pictures. To overcome the perceived inadequacy of the 8-bit quantization a word size is necessary large enough to ensure that the noise generation is insignificant in the normal processing and that the maintenance of the quality is given also in critical conditions. Also for other TV standards, e.g. PAL and NTSC, the invention can be applied.

## Claims

1. Method for A/D conversion wherein digital values with improved bit resolution are generated at a sampling frequency fₛ, having included the steps of:
- adding a D/A converted (36) periodic signal (21) varying in a number of steps and having a sampling frequency of n*fₛ (32) to the analog signal prior to an A/D conversion (33), wherein the peak to peak amplitude (20) of said periodic signal (21) equals one half of the corresponding quantisation interval of said A/D conversion (33), wherein the A/D conversion is done with predefined bit resolution and a sampling frequency of n*fₛ,
- converting the A/D converted digital signal in a conversion filter (34) to an output signal having an increased bit resolution wherein the bits for increasing the bit resolution correspond to the number of steps of the periodic signal, wherein the response of said conversion filtering has high attenuation or zero crossings at multiples of said sampling frequency fₛ, except for frequencies m*n* fₛ, m = 0, ±1, ±2, ±3, ...,
- subsampling said output signal (35) into a signal having a sampling frequency fₛ.

2. Method for D/A conversion of a signal having a sampling frequency fs, **characterized in** that said input signal (50) has an increased bit resolution and is at first oversampled (51) with a frequency of n*fₛ, second intermediate values are interpolated (52), third the resulting values are added (53) to a periodic signal (21) which varies in a number of steps corresponding to the number of bits used for increasing the bit resolution of said input signal, wherein said periodic signal has a sampling frequency of n*fₛ, fourth the sum signal is quantised (54) to a signal with predefined normal bit resolution which is D/A converted (55) by using the sampling frequency of n*fₛ, wherein the peak to peak amplitude (20) of said periodic signal (21) equals one half of the corresponding quantisation interval of said D/A conversion (55).

3. Method according to claim 1 or 2, **wherein** said periodic signal (21) is a staircase ramp signal.

4. Apparatus for carrying out the method according to claim 1 or 3, having included a summing circuit (32) which receives an analog input signal (30) and an output signal of a D/A converter (36) and having included a clock generator (38) which generates a clock signal having a clock frequency of n*fₛ, wherein said clock signal is fed to the D/A converter (36), the output of said summing circuit being connected with an A/D converter (33) having a predefined bit resolution, in particular 8 bit resolution, and which oversamples the input sum signal n-times with a sampling frequency n*fₛ, wherein a conversion filter (34) connected to the output of said A/D converter (33) is included which adds a number of bits, in particular n bits with n>1, to the input bits for bit resolution increase and which has high attenuation or zero crossings at multiples of said sampling frequency fₛ, except for frequencies m*n*fₛ, m = 0, ±1, ±2, ±3, ... , of a following subsampler (35) which subsamples the input signal by a factor n and which outputs a digital signal with increased bit resolution and a clock frequency fₛ, and having a periodic signal generator (37) which is connected to the input of said D/A converter (36), wherein the peak to peak amplitude (20) of the generated periodic signal (21) equals one half of the corresponding quantisation interval of said A/D converter (33).

5. Apparatus for carrying out the method of claim 2 or 3, **characterized in that** it includes an n-times oversampler (51) which receives a digital signal consisting of samples being produced with a clock frequency of fₛ and having a predefined increased bit resolution, in particular 8+n bit resolution with n>1, wherein said oversampler (51) generates a digital signal consisting of samples being produced with a clock frequency of n*fₛ, and having included a following conversion filter (52) which interpolates new samples based on the samples of said oversampler (51) and outputs the corresponding signal to an adder (53) which adds a periodic signal having the same clock frequency to the output signal of said conversion filter (52), wherein the periodic signal is generated in a periodic signal generator (58), further including a following quantiser (54) which extracts the most significant bits from the samples with increased bit resolution in the output signal of said adder (53), the thus generated new samples having a reduced bit resolution, in particular 8 bit resolution, further including a following D/A converter (55) which converts the bit reduced samples and to which a clock signal generated in a clock generator (38) is fed having a clock frequency of n*fₛ, wherein the peak to peak amplitude (20) of the periodic signal (21) generated in said periodic signal generator (58) equals one half of the corresponding quantisation interval of said D/A converter (55).

6. Apparatus according to claim 4 or 5, **wherein** said periodic signal generator (37, 58) is a n-bit counter.

## Patentansprüche

1. Verfahren zur A/D-Umwandlung, bei dem digitale Werte mit verbesserter Bit-Auflösung mit einer Abtastfrequenz fₛ erzeugt werden, das die folgenden Schritte einschließt:
- Hinzufügung eines D/A-umgewandelten (36) periodischen Signals (21), das sich in einer Anzahl von Schritten ändert und eine Abtastfrequenz von n*fₛ (32) hat, zu dem analogen Signal vor einer A/D-Umwandlung (33), wobei die Spitze-Spitze-Amplitude (20) des periodischen Signals (21) gleich der Hälfte des entsprechenden Quantisierungs-Intervalls der A/D-Umwandlung (33) ist, wobei die A/D-Umwandlung mit vordefinierter Bit-Auflösung und einer Abtastfrequenz von n*fₛ vorgenommen wird,
- Umwandlung des A/D-umgewandelten digitalen Signals in einem Umwandlungsfilter (34) in ein Ausgangssignal, das eine erhöhte Bit-Auflösung hat, wobei die Bits zur Erhöhung der Bit-Auflösung der Zahl von Schritten des periodischen Signals entsprechen, wobei das Ansprechen der Umwandlungs-Filterung eine hohe Dämpfung oder Null-Durchgänge bei Vielfachen der Abtastfrequenz fₛ hat, mit Ausnahme für Frequenzen m*n*fₛ, m = 0, ±1, ±2, ±3, ....
- Unterabtastung des Ausgangssignals (35) in ein Signal, das eine Abtastfrequenz fₛ hat.

2. Verfahren zur D/A-Umwandlung eines Signals, das eine Abtastfrequenz fₛ hat, dadurch gekennzeichnet, daß das Eingangssignal (50) eine erhöhte Bit-Auflösung hat und erstens mit einer Frequenz von n*fₛ überabgetastet wird (51), zweitens werden Zwischenwerte interpoliert (52), drittens werden die resultierenden Signale einem periodischen Signal (21) hinzugefügt (53), das sich in einer Anzahl von Schritten ändert, die der Zahl der Bits entsprechen, die zur Erhöhung der Bit-Auflösung des Eingangssignals verwendet werden, wobei das periodische Signal eine Abtastfrequenz von n*fₛ hat, viertens wird das Summensignal zu einem Signal mit vordefinierter normaler Bit-Auflösung quantisiert (54), das unter Verwendung der Abtastfrequenz von n*fₛ D/A-umgewandelt wird (55), wobei die Spitze-Spitze- Amplitude (20) des periodischen Signals (21) gleich der Hälfte des entsprechenden Quantisierungs-Intervalls der D/A-Umwandlung (55) ist.

3. Verfahren nach Anspruch 1 oder 2, bei dem das periodische Signal (21) ein Treppen-(staircase)-Rampensignal ist.

4. Vorrichtung zur Durchführung des Verfahrens nach Anspruch 1 oder 3, mit einer Summenschaltung (32), die ein analoges Eingangssignal (30) und ein Ausgangssignal von einem D/A-Wandler (36) empfängt, und mit einem Taktgenerator (38), der ein Taktsignal mit einer Frequenz n*fₛ erzeugt, wobei das Taktsignal dem D/A-Wandler (36) zugeführt wird, wobei der Ausgang der Summenschaltung mit einem A/D-Wandler (33) verbunden ist, der eine vordefinierte Bit-Auflösung, insbesondere eine 8-Bit-Auflösung hat, und der das Eingangs-Summensignal ein n-mal mit einer Abtastfrequenz n*fₛ überabtastet, wobei ein Umwandlungs-Filter (34) eingeschlossen ist, das mit dem Ausgang des A/D-Wandlers verbunden ist, und das den Eingangs-Bits für die Bit-Auflösungs-Erhöhung eine Anzahl von Bits, insbesondere n Bits mit n>1 hinzufügt, und das eine hohe Dämpfung oder Null-Durchgänge bei Vielfachen der Abtastfrequenz fₛ mit Ausnahme für Frequenzen von m*n*fₛ, m = 0, ±1, ±2, ±3, ... eines folgenden Unterabtasters (35) hat, der das Eingangssignal mit einem Faktor n unterabtastet, und der ein digitales Signal mit erhöhter Bit-Auflösung und eine Taktfrequenz fₛ ausgibt, und mit einem periodischen Signalgenerator (37), der mit dem Eingang des D/A-Wandlers (36) verbunden ist, wobei die Spitze-Spitze-Amplitude (20) des erzeugten periodischen Signals (21) gleich der Hälfte des entsprechenden Quantisierungs-Intervalls des A/D-Wandlers (33) ist.

5. Vorrichtung zur Durchführung des Verfahrens nach Anspruch 2 oder 3, dadurch gekennzeichnet, daß sie einen n-mal-Überabtaster (51) enthält, der ein digitales Signal empfängt, das aus Abtastungen besteht, die mit einer Taktfrequenz fₛ erzeugt werden und eine vordefinierte erhöhte Bit-Auflösung, insbesondere eine 8 + n-Bit-Auflösung mit n>1 haben, wobei der Überabtaster (51) ein digitales Signal erzeugt, das aus Abtastungen besteht, die mit einer Taktfrequenz von n*fₛ erzeugt werden, und die ein folgendes Umwandlungs-Filter (52) enthält, das neue Abtastungen, die auf den Abtastungen des Überabtasters (51) beruhen, interpoliert und das entsprechende Signal an eine Addierschaltung (53) ausgibt, die ein periodisches Signal, das dieselbe Taktfrequenz hat, dem Ausgangssignal des Umwandlungs-Filters (52) hinzufügt, wobei das periodische Signal in einem periodischen Signalgenerator (58) erzeugt wird, die ferner einen folgenden Quantisierer (54) enthält, der die bedeutsamsten Bits aus den Abtastungen mit erhöhter Bit-Auflösung in dem Ausgangssignal der Addierstufe (53) herauszieht, wobei die so erzeugten neuen Abtastungen eine verminderte Bit-Auflösung, insbesondere eine 8-Bit-Auflösung haben, die ferner einen folgenden D/A-Wandler (55) enthält, der die Bit-reduzierten Abtastungen umwandelt, und dem ein in einem Taktgenerator (38) erzeugtes Taktsignal zugeführt wird, das eine Taktfrequenz von n*fₛ hat, wobei die Spitze-Spitze-Amplitude (20) des in dem periodischen Signalgenerator (58) erzeugten periodischen Signals (21) gleich der Hälfte des entsprechenden Quantisierungs-Intervalls des D/A-Wandlers (55) ist.

6. Vorrichtung nach Anspruch 4 oder 5, bei der der periodische Signalgenerator (37, 58) ein n-Bit-Zähler ist.

## Revendications

1. Méthode de conversion A/N dans laquelle des valeurs numériques d'une résolution binaire améliorée sont générées à une fréquence d'échantillonnage fs, comportant les étapes de :
- addition d'un signal périodique (21) ayant subi une conversion N/A (36) variant en un certain nombre de pas et ayant une fréquence d'échantillonnage de n*fs (32) au signal analogique avant une conversion A/N (33), dans laquelle l'amplitude crête à crête (20) dudit signal périodique (21) est égale à une moitié de l'intervalle de quantification correspondant de ladite conversion A/N (33), dans laquelle la conversion A/N est réalisée avec une résolution binaire prédéfinie et une fréquence d'échantillonnage de n*fₛ,
- conversion du signal numérique ayant subi une conversion A/N dans un filtre de conversion (34) en un signal de sortie ayant une résolution binaire accrue dans laquelle les bits pour augmenter la résolution binaire correspondent au nombre de pas du signal périodique, dans laquelle la réponse dudit filtrage de conversion a une haute atténuation ou des passages au zéro à des multiples de ladite fréquence d'échantillonnage fₛ, sauf pour des fréquences m*n* fₛ, m = 0, ±1, ±2, ±3,...,
- sous-échantillonnage dudit signal de sortie (35) en un signal ayant une fréquence d'échantillonnage fs.

2. Méthode de conversion N/A d'un signal ayant une fréquence d'échantillonnage fₛ, caractérisée en ce que ledit signal d'entrée (50) a une résolution binaire accrue et premièrement est suréchantillonné (51) avec une fréquence de n*fs, deuxièmement des valeurs intermédiaires sont interpolées (52), troisièmement les valeurs résultantes sont ajoutées (53) à un signal périodique (21) qui varie en un certain nombre de pas correspondant au nombre de bits utilisés pour augmenter la résolution binaire dudit signal d'entrée, dans laquelle ledit signal périodique a une fréquence d'échantillonnage de n*fs, quatrièmement le signal de somme est quantifié (54) en un signal à résolution binaire inférieure prédéfinie qui a subi une conversion N/A (55) en utilisant la fréquence d'échantillonnage de n*fs, dans laquelle l'amplitude crête à crête (20) du signal périodique (21) est égale à la moitié de l'intervalle de quantification correspondant de ladite conversion N/A (55).

3. Méthode selon la revendication 1 ou 2, dans laquelle ledit signal périodique (21) est un signal en escalier.

4. Dispositif pour exécuter la méthode selon la revendication 1 ou 3, comportant un circuit de sommation (32) qui reçoit un signal d'entrée analogique (30) et un signal de sortie d'un convertisseur N/A (36) et comportant un générateur d'horloge (38) qui génère un signal d'horloge qui a une fréquence d'horloge de n*fs, dans lequel ledit signal d'horloge est passé au convertisseur N/A (36), la sortie dudit circuit de sommation étant connectée à un convertisseur A/N (33) ayant une résolution binaire prédéfinie, en particulier une résolution de 8 bits, et qui suréchantillonne le signal de somme d'entrée n fois avec une fréquence d'échantillonnage n*fs, dans lequel un filtre de conversion (34) connecté à la sortie dudit convertisseur A/N (33) est inclus ajoutant un certain nombre de bits, en particulier n bits avec n>1, aux bits d'entrée pour une augmentation de la résolution binaire et qui a une haute atténuation ou des passages au zéro à des multiples de ladite fréquence d'échantillonnage fs, sauf pour des fréquences m*n*fs, m = 0, ±1, ±2, ±3,..., d'un sous-échantillonneur suiveur (35) qui sous-échantillonne le signal d'entrée par un facteur n et qui sort un signal numérique d'une résolution binaire accrue et une fréquence d'horloge fs, et ayant un générateur de signaux périodiques (37) qui est connecté à l'entrée dudit convertisseur N/A (36), dans lequel l'amplitude crête à crête (20) du signal périodique généré (21) est égale à la moitié de l'intervalle de quantification correspondant dudit convertisseur A/N (33).

5. Dispositif pour exécuter la méthode selon la revendication 2 ou 3, caractérisé en ce qu'il comprend un suréchantillonneur par n fois (51) qui reçoit un signal numérique consistant en échantillons produits à une fréquence d'horloge de fs et ayant une résolution binaire accrue prédéfinie, en particulier une résolution binaire de 8+n bits avec n>1, dans lequel ledit suréchantillonneur (51) génère un signal numérique consistant en échantillons produits avec une fréquence d'horloge de n*fs, et incluant un filtre de conversion suiveur (52) qui interpole de nouveaux échantillons en se basant sur les échantillons dudit suréchantillonneur (51) et sort le signal correspondant à un additionneur (53) qui ajoute un signal périodique ayant la même fréquence d'horloge au signal de sortie dudit filtre de conversion (52), dans lequel le signal périodique est généré dans un générateur de signaux périodiques (58), comportant en outre un quantificateur suiveur (54) qui extrait les bits de poids fort des échantillons à résolution binaire accrue dans le signal de sortie dudit additionneur (53), les nouveaux échantillons ainsi générés ayant une résolution binaire réduite, en particulier une résolution de 8 bits, comportant en outre un convertisseur N/A suiveur (55) qui convertit les échantillons à bits réduits et auquel est passé un signal d'horloge généré dans un générateur d'horloge (38) ayant une fréquence d'horloge de n*fs, dans lequel l'amplitude crête à crête (20) du signal périodique (21) généré dans ledit générateur de signaux périodiques (58) est égale à la moitié de l'intervalle de quantification correspondant dudit convertisseur N/A (55).

6. Dispositif selon la revendication 4 ou 5, dans lequel ledit générateur de signaux périodiques (37, 58) est un compteur de n bits.
